# FASCICULE DE BREVET EUROPEEN

(11) **EP 1 155 603 B1**
(45) Date de publication et mention de la délivrance du brevet: **05.03.2003**
(21) Numéro de dépôt: 00900531.5
(22) Date de dépôt: 06.01.2000
(51) Int. Cl.: H05K 3/34, H05K 3/36

(54) **PROCEDE DE REALISATION DE MODULES ELECTRONIQUES A CONNECTEUR A BILLES OU A PREFORMES INTEGREES BRASABLES SUR CIRCUIT IMPRIME ET DISPOSITIF DE MISE EN OEUVRE**
VERFAHREN ZUR HERSTELLUNG VON ELEKTRONISCHEN MODULEN MIT AUF EINER LEITERPLATTE LÖTBAREN INTEGRIERTEN KUGEL- ODER FORMKÖRPERVERBINDERN UND VORRICHTUNG ZUR DURCHFÜHRUNG DES VERFAHRENS
METHOD FOR MAKING ELECTRONIC MODULES WITH BALL CONNECTOR OR WITH INTEGRATED PREFORMS CAPABLE OF BEING SOLDERED ON A PRINTED CIRCUIT AND IMPLEMENTING DEVICE

(30) Priorité: 05.02.1999 FR 9901390
(43) Date de publication de la demande: 21.11.2001
(73) Titulaire: Novatec S.A., 82000 Montauban (FR)
(72) Inventeur: BOURRIERES, Francis, 82000 Montauban (FR); KAISER, Clément, 82000 Montauban (FR)
(86) Numéro de dépôt international: FR0000018
(87) Numéro de publication internationale: WO00047027

(56) Documents cités:
- EP-A- 0 650 795
- DE-A- 4 326 104
- DE-A- 19 648 728
- US-A- 5 758 409
- PATENT ABSTRACTS OF JAPAN vol. 98, no. 8, 30 juin 1998 (1998-06-30) & JP 10 074887 A (SONY CORP), 17 mars 1998 (1998-03-17)
- PATENT ABSTRACTS OF JAPAN vol. 1998, no. 11, 30 septembre 1998 (1998-09-30) & JP 10 163263 A (NEC CORP), 19 juin 1998 (1998-06-19)
- PATENT ABSTRACTS OF JAPAN vol. 1997, no. 9, 30 septembre 1997 (1997-09-30) & JP 09 130031 A (HITACHI), 16 mai 1997 (1997-05-16)
- PATENT ABSTRACTS OF JAPAN vol. 1996, no. 7, 31 juillet 1996 (1996-07-31) & JP 08 064983 A (MATSUSHITA ELECTRIC IND CO), 8 mars 1996 (1996-03-08)

## Description

La présente invention concerne un procédé de réalisation de modules électroniques qui comprennent des composants montés en surface ainsi que des billes ou préformes d'interconnexion sur la même face d'un substrat.

Les modules électroniques sont de plus en plus utilisés car ils offrent de multiples avantages. Par exemple, ils permettent d'augmenter la densité de composants et ainsi de mettre plus de fonctionnalités dans un volume identique. Ils permettent également de réduire le nombre de composants à reporter pour l'assemblage final des cartes électroniques et de réduire ainsi les opportunités de défauts car le module pourra être assemblé et testé séparément puis reporté comme un composant sur la carte.

Traditionnellement les modules électroniques sont réalisés par montage de composants de surface appelés CMS sur un substrat céramique ou verre epoxy. Puis, pour interconnecter le module ainsi obtenu avec la carte électronique qui doit le recevoir plusieurs techniques sont utilisables. Par exemple des broches brasées à plat sur le substrat permettent d'interconnecter le module perpendiculairement à une autre carte électronique en insérant la partie dépassante de ces broches dans les trous de traversées de cette dernière, le brasage du module se faisant alors par brasage à la vague ou éventuellement en reprise manuelle.

Ces modules présentent plusieurs inconvénients comme par exemple un coût de fabrication et de mise en oeuvre élevé car d'une part la mise en place des broches est difficilement automatisable et d'autre part l'insertion des broches dans les trous de traversées doit se faire manuellement car les modules insérés verticalement ne se prêtent pas à la préhension automatique par dépression comme cela est pratiqué pour les composants CMS. De plus, ces modules ne permettent pas d'atteindre des densités très importantes vu le nombre limité de broches d'interconnexion. Enfin l'encombrement de ces modules est difficilement compatible avec les besoins de miniaturisation de l'électronique moderne.

Un autre mode de réalisation de modules électroniques consiste à placer un connecteur femelle sur le module et un connecteur mâle sur la carte réceptrice du module. Dans ce cas de figure également la mise en place du module doit se faire manuellement et le coût de ces connecteurs reste important.

Un autre mode de réalisation de modules électroniques, selon l'art antérieur consiste à placer les composants CMS sur la face supérieure d'un substrat céramique ou verre époxy et de réaliser les interconnexions sur l'autre face en y reportant et en y brasant des billes. Ce module peut alors être reporté et brasé sur une carte électronique de la même façon qu'un composant à billes standard. Le prix de réalisation de ce type de module reste important car le billage constitue une opération supplémentaire. De plus la préhension par dépression peut quelquefois s'avérer difficile à mettre en oeuvre car les composants présents sur la face supérieure peuvent être un obstacle au passage de la pipette de préhension.

Les brevets US5838545 et US5675183 font état d'un module électronique comprenant en face supérieure un radiateur et en face inférieure des circuits intégrés qui sont au milieu de membres d'interconnexions qui permettent de relier le module à un niveau suivant. Ces brevets ne donnent pas d'indication sur le procédé de réalisation de ce type de module électronique. Précisément on verra dans la description suivante que la présente invention constitue un procédé pouvant permettre de fabriquer des modules électroniques de ce type là, à un coût plus bas que l'art antérieur tel qu'il est connu dans ces brevets.

Les brevets US5570274 et US5027191 décrivent d'autres modules électroniques pour lesquels les éléments d'interconnexions entre le module et le circuit imprimé récepteur de ce module sont sur un plan différent de celui qui comporte les composants électroniques. Pour réaliser ce décalage entre les plans, soit on réalise une cavité dans laquelle les composants sont reportés, soit on dispose une pièce entretoise qui permet de mettre les éléments d'interconnexion en surépaisseur. Dans ces cas encore la présente invention apporte une solution permettant de réaliser ces modules plus simplement et donc à un coût moindre.

Le procédé objet de la présente invention permet de remédier aux problèmes de l'art antérieur, mais résout également quelques autres difficultés comme cela apparaîtra dans la suite.

Les problèmes sont résolus conformément à l'invention par la partie caractéristique de la revendication 1.

Un mode particulier de réalisation de cette invention se caractérise en ce que :
- il est fait usage d'un substrat comportant sur une même face des plages d'accueil adaptées d'une part aux composants CMS pour assurer la fonction électronique du module et d'autre part aux billes qui permettent d'assurer la liaison électrique et mécanique entre le module et le circuit imprimé qui doit recevoir ce module,
- il est déposé en une seule et même opération, une crème à braser sur les dites plages correspondantes aux composants CMS ainsi qu'à celles correspondantes aux billes ou préformes d'interconnexion. Le procédé de dépôt de crème à braser par sérigraphie est particulièrement adapté pour réaliser ce dépôt simultanément sur les plages des CMS et des billes, mais il est également envisageable de réaliser ce dépôt de crème à braser grâce à un dosage par seringue.
- les dites billes d'interconnexion, généralement en étain-plomb haute température comme par exemple en alliage 90 % de plomb et 10 % d'étain présentent un diamètre supérieur à la hauteur du composant électronique le plus haut constituant le module,
- les dits composants CMS et les dites billes d'interconnexion sont reportés l'un à la suite de l'autre sur les dépôts de crème à braser précédemment effectués sur le substrat du module,
- les dites billes sont reportées toutes simultanément à la manière d'un composant CMS, à l'aide d'un dispositif approprié,
- un cycle de température permet de refusionner la crème à braser afin de braser à la fois les dits composants CMS ainsi que les billes d'interconnexion,
- le module ainsi obtenu est directement connectable sur un circuit imprimé à la manière de tout autre composant ayant des connexions à billes.

Comme les composants électroniques et les billes sont sur la même face du substrat, les éléments d'interconnexion sont réalisés dans la même opération que la fonction électronique du module, ce qui permet de réaliser la fonction interconnexion à un prix voisin d'un centime par connexion, alors que l'on atteint facilement 10 centimes par connexion selon l'art antérieur.

De plus, les composants électroniques étant disposés sur le même côté que les billes d'interconnexion, l'autre est donc dégagé afin de permettre la préhension du module par dépression comme tout autre composant CMS.

D'autre part, il est possible en disposant les billes d'interconnexion de façon périmétrique aux composants électroniques et en plusieurs rangées si nécessaire, ce qui accroît considérablement la densité possible d'interconnexion et en prévoyant un plan de masse sur le substrat, qui peut naturellement être multicouche, de réaliser un blindage électromagnétique du module sans opération supplémentaire alors qu'habituellement ces blindages sont réalisés par adjonction d'un capot métallique sur les composants susceptibles d'émettre ou d'être sensible au rayonnement électromagnétique. Ces capots sont particulièrement perturbateurs dans la gamme de fabrication des cartes électroniques, car non seulement ils constituent des pièces supplémentaires mais de plus ils sont difficiles à braser.

Ce procédé peut aussi permettre de réaliser des boîtiers à billes à faible pollution électromagnétique. Il est ainsi possible d'intégrer des composants électroniques, type condensateur de découplage dans la même phase de travail que le billage des BGA. Avec la généralisation des circuits à logiques rapides, le filtrage des alimentations et des entrées / sorties des circuits intégrés, de grandes dimensions pose un problème mal résolu jusqu'à aujourd'hui. En effet, les nombreuses connexions convergeant vers le boîtier ne laissent que peu de place à l'implantation des éléments de filtrage. Ces derniers sont alors implantés loin du boîtier et les problèmes de compatibilité électromagnétique apparaissent alors :
- rayonnements électromagnétiques des horloges et des signaux rapides,
- susceptibilité aux rayonnements extérieurs, avec disfonctionnements du système.

Devant l'exigence des normes CE, ces problèmes ne sont plus admissibles aujourd'hui et sont résolus par la mise en place de blindages. Cependant, la mise en place de blindages est une opération coûteuse qui exige des compétences pas toujours disponibles. L'expérience montre que dans de nombreux cas, il suffirait de réduire les rayonnements de dix ou quinze décibels pour atteindre la conformité aux normes. Notre solution apporte une amélioration de cet ordre, et permet ainsi très souvent au concepteur de se passer de blindage. Ce nouveau système de boîtier à billes apporte une solution optimisée aux problèmes de compatibilité électromagnétique en permettant l'implantation des composants à proximité de la puce du circuit intégré. Plus précisément, ce boîtier autorise l'implantation de composants sur sa face inférieure, parmi les billes de connexions.

On comprendra aisément l'intérêt de placer par exemple le condensateur de découplage d'alimentation entre la bille du plus alimentation et la bille de masse : les impulsions de courant restent localisées sur un circuit très court, ce qui réduit fortement les rayonnements électromagnétiques et la pollution de la carte.

Le problème du rayonnement des horloges est également résolu, en implantant les condensateurs d'adaptation du quartz au plus près de la puce, entre les billes de sortie et une masse locale située sur le boîtier. Le rayonnement pourra encore être réduit en implantant une résistance directement sur le boîtier, en série avec la sortie de la porte oscillatrice. Le rayonnement en très haute fréquence se trouve considérablement réduit car la sortie de la porte n'est plus chargée par les capacités de la carte. D'une façon générale, toutes les sorties à front raides peuvent être ainsi chargées par une petite résistance série, sur le boîtier lui-même.

Certaines entrées sont susceptibles d'être perturbées par des signaux R.F. et exigent de ce fait un filtrage de ces signaux. Il s'agit par exemple des entrées analogiques des convertisseurs digitaux analogiques ou bien des entrées analogiques bas niveaux. Avec l'avènement des circuits logiques à basse tension, les perturbations R.F. peuvent même affecter les entrées logiques. Notre système permettra d'implanter une cellule de filtrage directement sur le boîtier, parmi les billes. Les dimensions réduites de ce circuit le protégeront contre les rayonnements perturbateurs, notamment ceux des tests des essais compatibilité à la norme CE.

D'autres avantages et caractéristiques de l'invention apparaîtront à la lecture de la description ci-après de l'invention illustrée par les dessins joints dans lesquels :
- les figures 1 et 2 illustrent des modules électroniques selon l'art antérieur,
- la figure 3 illustre un module électronique réalisé selon la présente invention,
- la figure 4 montre la gamme de réalisation d'un module selon la présente invention.
- la figure 5 montre un dispositif de préhension adapté à la présente invention,
- la figure 6 montre un autre dispositif de préhension selon l'invention, adapté à un circuit en trois dimensions,
- la figure 7 illustre le type de module pouvant être réalisé grâce à la présente invention,
- en figure 8 est représenté schématiquement un BGA avec ses billes de connexions et des CMS associés,
- en figure 9 est représenté un circuit à billes nu sans composant (ni puce, ni CMS) ayant une fonction unique de blindage,
- en figure 10 est représenté un circuit à billes qui est un module réalisant simultanément une fonction et un blindage.

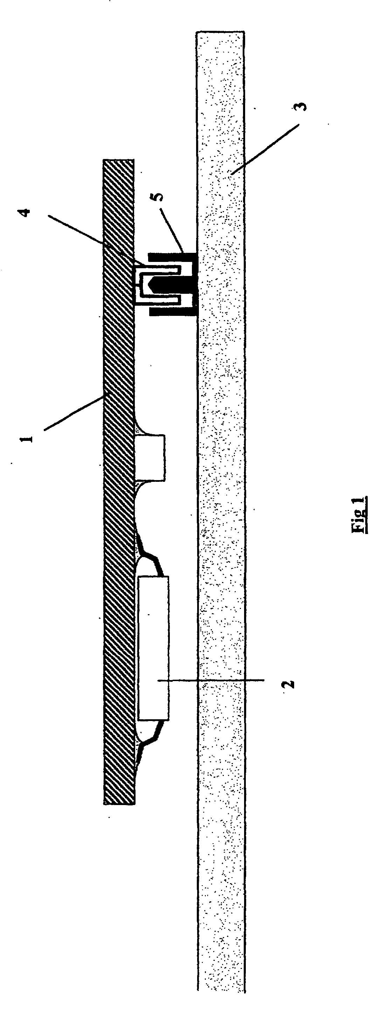

En figure 1 est représenté un module électronique de l'art antérieur constitué par un substrat 1, des composants 2 et un connecteur femelle 4 qui est connecté sur un circuit imprimé 3 par le biais du connecteur mâle 5. Dans ce cas de figure il est donc nécessaire de braser d'une part un connecteur mâle sur le module et d'autre part un connecteur femelle sur le circuit imprimé ce qui ajouté au prix du connecteur rend cette technique très coûteuse. D'autre part, afin de réduire le nombre de connecteurs cette technique oblige le concepteur de la carte et du module à ramener toutes les entrées et toutes les sorties au même endroit ce qui génère des contraintes d'encombrement et de conception de produit.

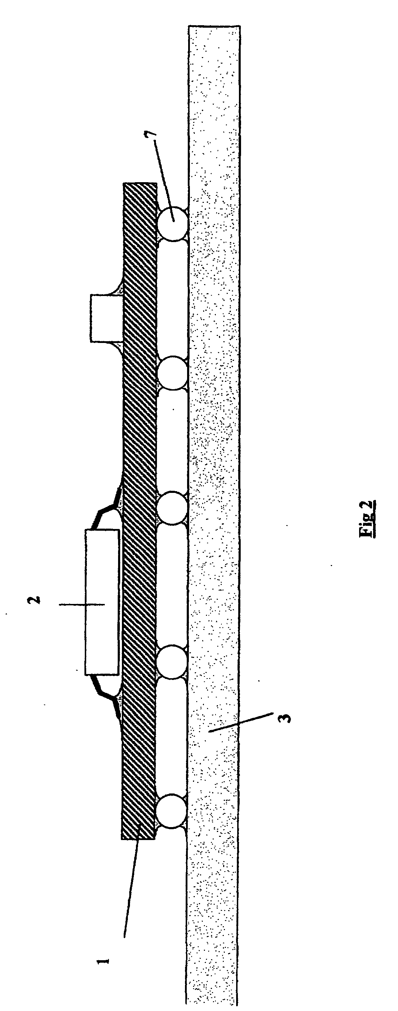

En figure 2 est représenté en coupe un autre module électronique de l'art antérieur constitué par un substrat 1 des composants 2 et est interconnecté sur le circuit imprimé 3 par le biais des billes 7. Dans ce cas l'opération de billage du module se fait après équipement du substrat par les composants électroniques et nécessite donc un dépôt de crème à braser supplémentaire sur le substrat, une opération de report de billes sur les dépôts de crème et nécessite une deuxième opération de refusion afin de réaliser le brasage des billes sur le substrat. Cette solution, bien qu'elle soit intéressante au niveau de la densité de composants qu'elle permet d'atteindre, reste une solution coûteuse et donc difficilement généralisable sur des produits de grande diffusion.

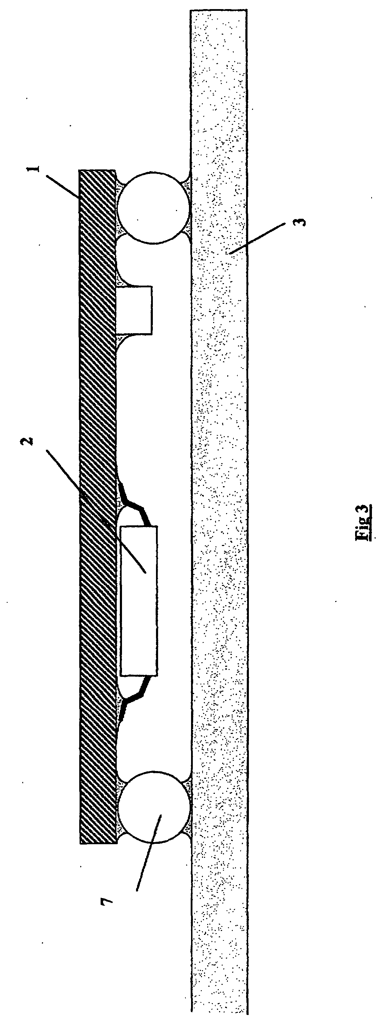

En figure 3, est représenté en coupe un module réalisé selon la présente invention. Les billes 7 et les composants 2 sont dans ce cas reportés sur la même face du substrat 1. L'interconnexion avec le circuit imprimé 3 se faisant donc par le biais des billes 7 qui sont d'un diamètre suffisant pour permettre de placer les composants entre le substrat 1 et le circuit imprimé 3 sans interférence mécanique.

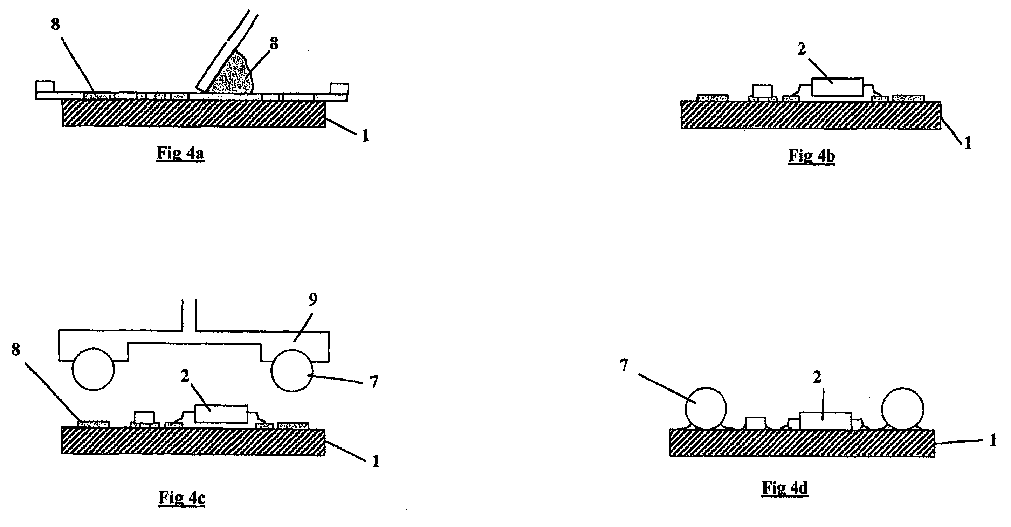

En figure 4, est représentée la gamme de fabrication d'un module électronique selon la présente invention. Dans un premier temps, on procède à une opération de dépôt par sérigraphie de crème à braser 8 sur les plages d'accueil relatives aux composants électroniques ainsi qu'aux billes sur le substrat 1. Puis on procède à l'opération de report des composants électroniques 2 sur le substrat selon des moyens connus, suivie par la prise et le report collectif des billes 7 grâce au préhenseur 9. Finalement on procède à l'opération de refusion de la crème à braser qui permet de braser les composants électroniques et les billes simultanément sur le substrat. Il est à noter qu'il est envisageable d'intervertir l'ordre de report des composants et des billes sans que cela remette en cause la présente invention.

Le procédé selon la présente invention est donc un moyen de produire des modules électroniques qui sont particulièrement bon marché et qui de plus peuvent présenter des caractéristiques de blindage sans qu'il soit nécessaire de rajouter des pièces complémentaires. Le dispositif objet de la demande de brevet FR98.13424 du même inventeur publiée après la date de priorité de la demande, est particulièrement apte à mettre à disposition des billes d'interconnexion afin de les reporter simultanément à l'aide d'un préhenseur. De plus, pour plus de facilité le préhenseur peut être lamé au droit des composants de surface afin d'éviter toute interférence entre les composants présents sur le module au moment de l'opération de report des billes.

Il est également à noter qu'il est envisageable de reporter en plus des composants CMS, des puces directement sur le module électronique soit sur la même face que les billes d'interconnexion et / ou sur l'autre face.

Pour augmenter encore la densité de composants sur le module, des composants CMS brasés en même temps que les billes d'interconnexion ou autres peuvent être reportés sur la face opposée à celle comportant les billes d'interconnexion.

Pour mettre en oeuvre le dit procédé, il est nécessaire d'échapper aux contraintes d'encombrement liées à des composants aussi différents que les composants CMS ou encore à des obstacles pouvant être présents à la surface du substrat et les billes ou préformes de connexion. Dans la gamme de fabrication, il est préférable de déposer dans un premier temps, les composants électroniques et dans un deuxième temps les billes ou préformes, car ces dernières ont une surface de contact très faible et si leur tenue sur la crème à braser est certes suffisante à l'état statique, dès que l'on applique un mouvement avec des accélérations comme c'est le cas lors du transport sur les machines de pose de composants, les billes risquent de se déplacer et d'aller hors de leur plage d'accueil. Afin de contourner cet inconvénient, un dispositif servant à la préhension et au report des billes ou préformes présente une face de travail dont la topographie est adaptée d'une part aux dimensions et aux formes des billes ou préformes à saisir et d'autre part à échapper à tout contact avec les composants électroniques ou tout autre obstacle pouvant être présent à la surface du substrat et déjà en place lors de la pose des dites billes.

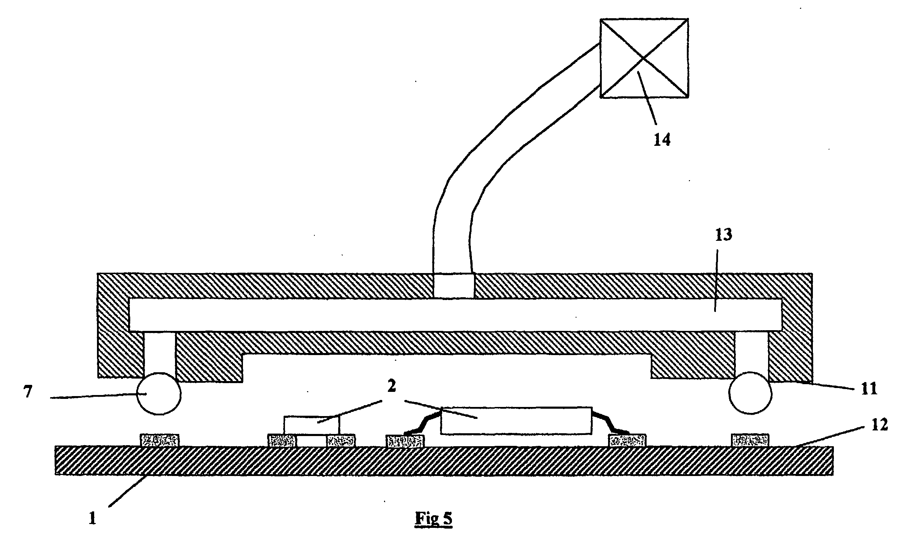

Selon un mode préférentiel de réalisation du dispositif de préhension ou de report représenté en figure 5, le préhenseur est doté d'une face de travail 11 parallèle à la face 12 du substrat 1 à équiper. Cette face de travail 11 possède un lamage permettant de ne pas interférer avec les composants lors de l'application des billes. Sur cette face de travail débouchent des orifices d'aspiration et de maintien de l'ensemble des billes ou préformes. Les orifices sont en communication avec une chambre à vide 13, elle-même en communication avec un générateur de vide 14. Ainsi lors de l'application d'une aspiration par le générateur de vide, les billes 7 sont aspirées et maintenues dans cette position. Le préhenseur peut alors être placé en vis à vis du substrat déjà équipé des composants électroniques de surface. Un mouvement de descente vertical du préhenseur est effectué jusqu'au contact des billes avec le substrat, l'aspiration est coupée, le préhenseur peut alors être relevé.

Selon une autre caractéristique le dispositif selon l'invention et en application du procédé est équipé d'orifices de saisie et de report de billes ou préformes en accord avec les pas interbilles. Ceux-ci sont généralement constants pour un même circuit, mais il est possible d'imaginer des pas différents.

Selon une autre caractéristique du dispositif selon l'invention, il est possible de poser des billes ou préformes sur des plans ou niveaux différents, ces billes ou préformes peuvent aussi être de diamètre ou de forme différente, dans ce cas la topographie de la face de travail du préhenseur est adaptée simultanément à la topographie du circuit imprimé qui peut être en trois dimensions et à la face définie par la partie inférieure des billes ou préformes. Dans tous les cas il y aura un parallélisme des faces entre la surface du substrat et la face définie par la partie inférieure des billes ou préformes.

Selon une autre caractéristique, le dispositif selon l'invention peut recevoir un moyen d'alimentation en billes ou préformes connues, ce peut être un réservoir où les billes ou préformes sont identiques entre elles mais disposées en vrac, ce peut être un dispositif tel que celui qui a fait l'objet de la demande de brevet n° FR98.13424 du même inventeur publiée après la date de priorité de la demande.

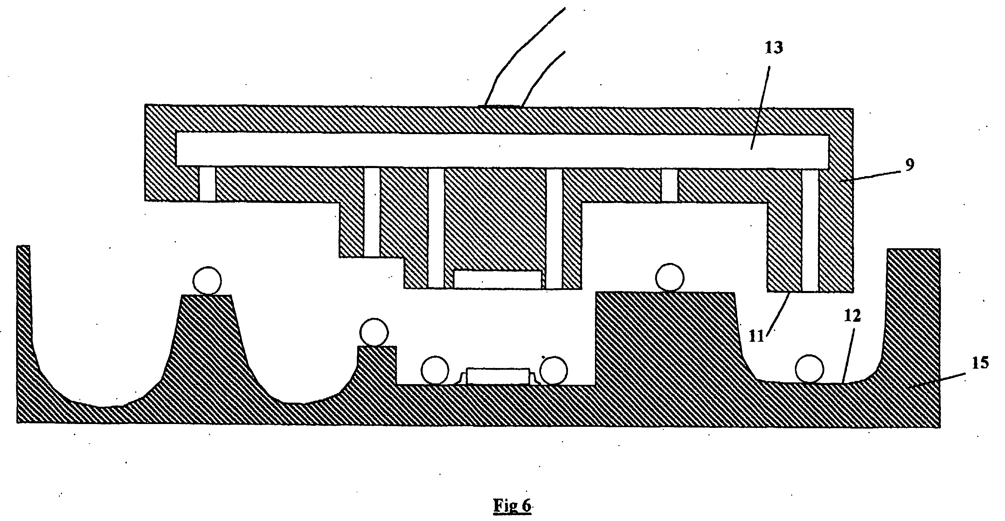

En figure 6, est représenté un circuit moulé 15 en trois dimensions. Le préhenseur 9 équipé d'une chambre à vide 13 possède une face de travail 11 en trois dimensions et à topographie adaptée. Ceci constitue un exemple supplémentaire de ce qu'il est possible de réaliser à partir de cette invention.

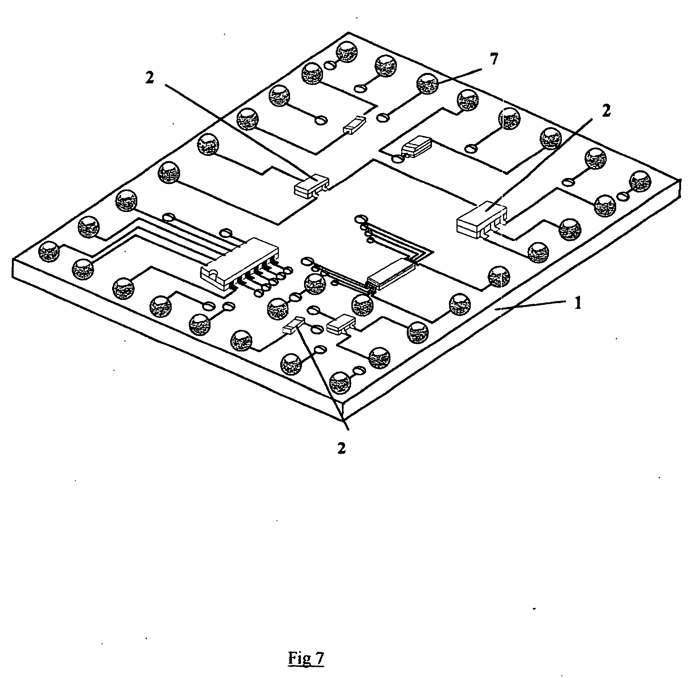

En figure 7 est représenté un exemple de module électronique qui peut être réalisé grâce à la présente invention. Les billes 7 et les composants 2 peuvent être disposés sur toute la surface du module, à la convenance du concepteur. Ainsi, il devient possible d'atteindre des densités très importantes et le concepteur de produits électroniques peut optimiser son produit.

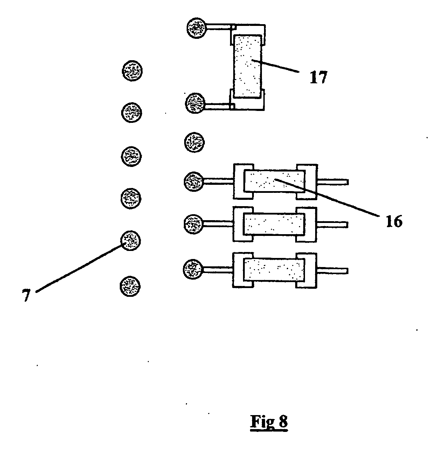

La figure 8, montre une implantation de composants sur le circuit à billes ; il sera bien sur possible de prévoir des emplacements de composants même si ceux-ci ne sont pas implantés, l'implantation étant configurable en fonction des besoins. En 17, figure un condensateur de découplage entre deux billes et en 16, figure des résistances en série avec les sorties.

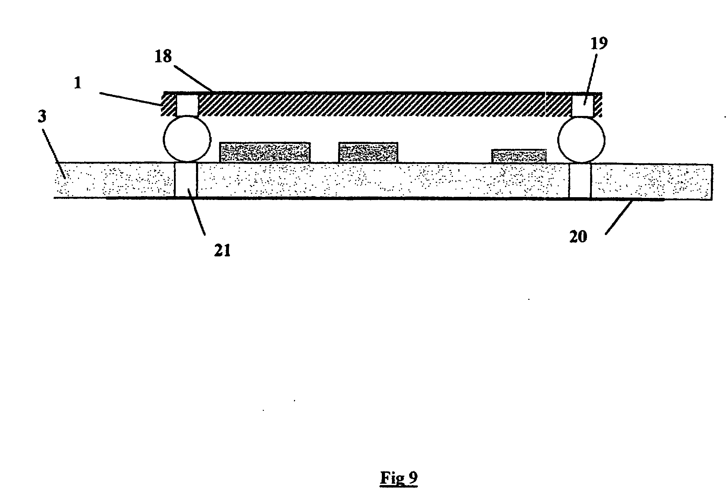

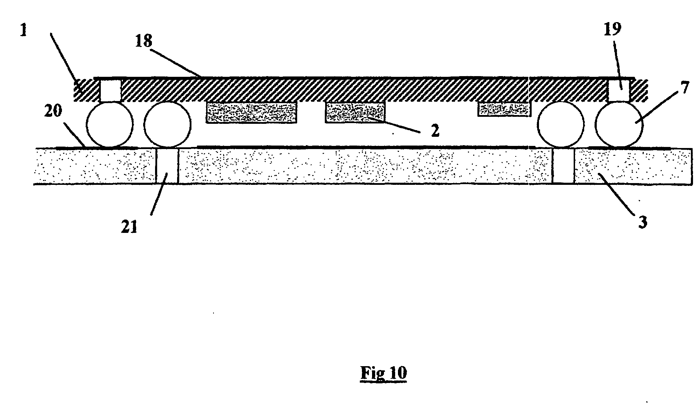

En plaçant des billes sur toute la périphérie du boîtier, on peut réaliser une cage de Faraday dont la hauteur est égale au diamètre des billes. Il suffira pour cela de créer deux plans de masse (un plan inférieur et un plan supérieur) reliés électriquement entre eux par des billes qui deviennent donc des billes de blindage par différence aux billes d'interconnexions qui permettent de relier électriquement les composants du module électronique au circuit imprimé récepteur du module. Plusieurs configurations sont possibles, selon les faces sur lesquelles sont disposées ces plans conducteurs. Premier exemple, en figure 9 : le circuit à billes sert uniquement de blindage. Un plan conducteur 18, est disposé sur la face supérieure du circuit à billes ; des traversées 19 conductrices relient les billes à ce plan. Les composants à blinder sont disposés sur le circuit principal 3. La face inférieure du circuit principal constitue le plan conducteur inférieur 20 qui est également relié aux billes 7 par le biais des traversées conductrices 21. Deuxième exemple, en figure 10 : le circuit à billes est lui-même un module réalisant une fonction (oscillateur, amplificateur R.F., filtre R.F., ...) dans ce cas le plan conducteur inférieur 20 est situé sur le dessus du circuit imprimé 3 et des traversées conductrices 21 permettent de ramener les signaux électriques sur la face inférieure du circuit imprimé 3. Il comporte des composants sur sa face inférieure. Dans toutes ces configurations, des billes conductrices font partie du blindage. La distance entre chaque bille aura bien sûr une influence sur l'efficacité de ce blindage, puisque l'intervalle entre chaque bille de blindage constitue un trou dans celui-ci. Pour des billes de deux millimètres de diamètre, et espacées de quatre millimètres, on obtient un blindage déjà très efficace même au delà du Gigahertz. Il est surtout important que chaque bille de blindage possède sa propre traversée de contact aux plans conducteurs inférieur et supérieur. La hauteur des composants susceptibles d'être ainsi enfermés est fonction du diamètre des billes.

## Revendications

1. Procédé de réalisation d'un module électronique qui se présente sous la forme d'un boîtier à billes associant un réseau de billes (7) ou de préformes géométriquement identiques d'interconnexion ou de blindage et des composants montés en surface (2) sur la même face d'un substrat (1), rendant ainsi ce module directement connectable par brasage à un circuit imprimé (3), **caractérisé en ce que** le dépôt de crème à braser (8) est fait simultanément pour les composants et le réseau de billes d'interconnexion ou de blindage situées sur la même face et que les dits composants sont reportés sur les plages d'accueil correspondantes et que les billes d'interconnexion de diamètre supérieur à la hauteur des dits composants sont reportés collectivement sur les plages de la même face qui leur sont destinées par un dispositif approprié et qu'un seul cycle de refusion permette de braser à la fois les composants et les billes d'interconnexion ou de blindage sur le substrat.

2. Procédé selon la revendication 1 **caractérisé en ce que** le dépôt de crème à braser (8) est réalisé par sérigraphie.

3. Procédé selon la revendication 1 **caractérisé en ce que** le dépôt de crème à braser (8) est réalisé par dosage par seringue.

4. Procédé selon les revendications 1 à 3, **caractérisé en ce qu'**il permet de réaliser un blindage électromagnétique (18) directement intégré au module électronique par des liaisons conductrices (19) (21) au plan de masse (20) du circuit (3).

5. Procédé selon les revendications 1 à 3 **caractérisé en ce qu'**il permet d'intégrer au plus près des connexions à billes (7) et sur la même face du module électronique des condensateurs de découplage (17) et/ou des résistances série (16) et/ou des cellules de filtrage et/ou des condensateurs d'adaptation de quartz.

6. Procédé selon les revendications 1 à 5, **caractérisé en ce que** le côté du module opposé à celui comprenant les billes et les composants permette la préhension du module par dépression.

## Patentansprüche

1. Verfahren zur Herstellung eines Elektronikmoduls, das die Form eines Gehäuses mit Kugeln aufweist, welches ein Netzwerk bzw. Raster von Kugeln (7) oder von geometrisch identischen Vorformlingen bzw. Rohlingen für die gegenseitige Verbindung oder die Abschirmung und an der Oberfläche (2) auf der gleichen Seite eines Substrats (1) montierte Bauteile vereinigt bzw. verbindet, was so dieses Modul durch Löten mit einer gedruckten Schaltung (3) direkt verbindbar macht, **dadurch gekennzeichnet, dass** die Ablagerung von Lötpaste (8) gleichzeitig für die Bauteile und das Netzwerk bzw. Raster von Kugeln für die gegenseitige Verbindung oder die Abschirmung, welche sich auf der gleichen Seite befinden, ausgeführt wird, und dass die Bauteile auf die entsprechenden Aufnahmebereiche übertragen werden, und dass die Kugeln für die gegenseitige Verbindung von einem Durchmesser, der größer als die Höhe der Bauteile ist, gemeinsam auf die Bereiche der gleichen Seite, die ihnen bestimmt sind, durch eine geeignete Vorrichtung übertragen werden, und dass es ein einziger Zyklus des Aufheizens bzw. -schmelzens gestattet, die Bauteile und die Kugeln für die gegenseitige Verbindung oder die Abschirmung auf einmal auf das Substrat zu löten.

2. Verfahren gemäß Anspruch 1, **dadurch gekennzeichnet, dass** die Ablagerung von Lötpaste (8) durch Siebdruck ausgeführt wird.

3. Verfahren gemäß Anspruch 1, **dadurch gekennzeichnet, dass** die Ablagerung von Lötpaste (8) mittels Dosierung durch eine Spritze ausgeführt wird.

4. Verfahren gemäß den Ansprüchen 1 bis 3, **dadurch gekennzeichnet, dass** es es gestattet, eine elektromagnetische Abschirmung (18) auszuführen, welche direkt in das Elektronikmodul durch leitende Verbindungen (19) (21) mit der Masseebene (20) der Schaltung (3) integriert ist.

5. Verfahren gemäß den Ansprüchen 1 bis 3, **dadurch gekennzeichnet, dass** es es gestattet, auf dem kürzesten Weg der Verbindungen mit Kugeln (7) und auf der gleichen Seite des Elektronikmoduls Kopplungskondensatoren (17) und/oder Reihenwiderstände (16) und/oder Filter- bzw. Glättungszellen und/oder Quarzanpassungskondensatoren zu integrieren.

6. Verfahren gemäß den Ansprüchen 1 bis 5, **dadurch gekennzeichnet, dass** die Seite des Moduls, die jener entgegengesetzt ist, welche die Kugeln und die Bauteile enthält, das Greifen des Moduls durch Unterdruck gestattet.

## Claims

1. Method for producing an electronic module in the shape of a ball housing combining a network of interconnection or shielding balls (7) or geometrically identical preforms and surface-mounted components (2) on the same side of a substrate (1), thus making this module directly connectable by soldering to a printed circuit (3), wherein soldering cream (8) is deposited simultaneously for the components and the interconnection or shielding balls located on the same surface and wherein the said components are transferred onto the corresponding mounting lands and wherein the interconnection balls with a diameter greater than the height of said components are transferred collectively onto the lands of the same side intended for them by an appropriate device and wherein a single reflow cycle permits simultaneous soldering of the components and the interconnection or shielding balls onto the substrate.

2. Method as claimed in claim 1, wherein the soldering cream (8) is deposited via serigraphy.

3. Method as claimed in claim 1, wherein the soldering cream (8) is deposited by syringe.

4. Method as claimed in claims 1 to 3, wherein it makes it possible to produce an electromagnetic shield (18) integrated directly into the electronic module by conducting connections (19)(21) to the ground plane (20) of the circuit (3).

5. Method as claimed in claims 1 to 3, wherein it makes it possible to integrate as close to the connecting balls (7) as possible and on the same side of the electronic module decoupling capacitors (17) and/or serial resistors (16) and/or filtering cells and/or quartz adapter condensers.

6. Method as claimed in claims 1 to 5, wherein the side of the module opposite the side comprising the balls and the components allows gripping of the module by suction.
